# EUROPÄISCHE PATENTSCHRIFT

(11) **EP 4 527 159 B1**
(45) Veröffentlichungstag und Bekanntmachung des Hinweises auf die Patenterteilung: **18.02.2026**
(21) Anmeldenummer: 23734915.4
(22) Anmeldetag: 19.06.2023
(51) Int. Cl.: H05K 7/14, H02M 7/00

(54) **LEISTUNGSMODUL, ELEKTRISCHES GERÄT UND VERFAHREN ZUR HERSTELLUNG EINES LEISTUNGSMODULS**
POWER MODULE, ELECTRICAL DEVICE AND METHOD FOR PRODUCING A POWER MODULE
MODULE DE PUISSANCE, APPAREIL ÉLECTRIQUE ET PROCÉDÉ DE FABRICATION D'UN MODULE DE PUISSANCE

(30) Priorität: 03.08.2022 EP 22188441
(43) Veröffentlichungstag der Anmeldung: 26.03.2025
(73) Patentinhaber: Siemens Aktiengesellschaft, 80333 München (DE)
(72) Erfinder: OCHS, Ewgenij, 90617 Puschendorf (DE)
(74) Vertreter: Siemens Patent Attorneys
(86) Internationale Anmeldenummer: PCT/EP2023/066370
(87) Internationale Veröffentlichungsnummer: WO 2024/027984

(56) Entgegenhaltungen:
- DE-A1- 102019 114 040
- US-A1- 2014 252 410

## Beschreibung

Die Erfindung betrifft ein Leistungsmodul aufweisend eine AC-Anschluss-Seite und eine, der AC-Anschluss-Seite gegenüberliegende DC-Anschluss-Seite, wobei das Leistungsmodul weiterhin eine Leiterplatte, zumindest einen, an der AC-Anschluss-Seite angeordneten Wechselspannungsanschluss sowie zumindest drei Gleichspannungsanschlüsse umfassend einen oder mehr mittlere Gleichspannungsanschlüsse sowie zwei äußere Gleichspannungsanschlüsse umfassend einen positiven Gleichspannungsanschluss und einen negativen Gleichspannungsanschluss umfasst, wobei einer der mittleren Gleichspannungsanschlüsse und einer der äußeren Gleichspannungsanschlüsse jeweils an der DC-Anschluss-Seite und bei einer Draufsicht außerhalb der Leiterplatte angeordnet sind.

Weiterhin betrifft die Erfindung ein jeweiliges elektrisches Gerät aufweisend zumindest ein jeweiliges, derartiges Leistungsmodul.

Schließlich betrifft die Erfindung ein Verfahren zur Herstellung eines derartigen Leistungsmoduls.

Derartige Vorrichtungen bzw. ein derartiges Verfahren kommen in einer Vielzahl von Anwendungen in der Leistungselektronik zum Einsatz. Beispielsweise werden in der Leistungselektronik Halbleiterbauelemente zur besseren Handhabung in Gehäusen, z.B. IGBT-Module, mit externen Anschlusstechnik verwendet, wobei IGBT für Bipolartransistor mit isolierter Gate-Elektrode, englisch "insulated-gate bipolar transistor", steht. Bei kleineren Leistungen sind die Anschlüsse als Pads aus dem Gehäuse, oftmals Package genannt, herausgeführt. Bei größeren Leistungen verwendet man Schraubanschlüsse mit größeren Auflageflächen, um darauf weitere Verbindungen, wie z.B. interne Stromschienen, anzuschließen. Wie alle anderen Bauteile in der Leistungselektronik werden auch an die IGBT-Module große Anforderungen gestellt. Die vorliegende Erfindung ist beispielsweise auf die Schraub-Anschlusstechnik der IGBT-Module für größere Leistungen anwendbar, insbesondere die IGBT-Module "EconoDual3" von Infineon Technologies AG, München, "SEMiX" von SEMIKRON Elektronik GmbH & Co. KG, Nürnberg oder "SD3" von Siemens AG, München.

Diese oben genannten IGBT-Module werden speziell für Anwendungen in 2-Level-Technologie genutzt, um z.B. eine einzelne Halbbrücke aus mehreren einzelnen IGBT-Halbleitern zu realisieren.

Aus der US8847328B1 ist Leistungshalbleitermodul mit vier Leistungsanschlüssen bekannt. Ein IGBT hat einen Kollektor, der mit dem ersten Leistungsanschluss verbunden ist, und einen Emitter, der mit dem dritten Leistungsanschluss gekoppelt ist. Eine antiparallele Diode ist parallel mit dem IGBT gekoppelt. Zwischen dem zweiten und dem vierten Leistungsanschluss ist eine Gleichspannungsverbindung angeschlossen. Der DC-Link kann zwei Dioden und zwei IGBTs umfassen, wobei die IGBTs in einer Konfiguration mit gemeinsamem Kollektor verbunden sind. Die ersten und zweiten Leistungsanschlüsse sind in einer ersten Linie entlang einer Seite des Moduls angeordnet, und die dritten und vierten Leistungsanschlüsse sind in einer zweiten Linie entlang der gegenüberliegenden Seite des Moduls angeordnet. Zwei identische Instanzen des Moduls können miteinander verbunden werden, um einen dreistufigen NPC-Phasenzweig mit niedrigen Streuinduktivitäten zu bilden, wobei der Phasenzweig zwei parallele Gleichstromverbindungen aufweist.

Aus der DE 10 2019 114 040 A1 ist ein Leistungsmodul mit einem Formgehäuse und drei Leistungsanschlüssen bekannt, die von einer ersten Seite des Formgehäuses vorstehen. Die Leistungsanschlüsse umfassen einen positiven Gleichstromanschluss, einen neutralen Anschluss und einen negativen Anschluss. Das Leistungsmodul umfasst eine Phasenausgangs-Netzklemme, die von einer zweiten Seite des Formgehäuses vorsteht. Das Leistungsmodul ist ein dreistufiges Leistungsmodul mit einer Vielzahl von Steuerpins die von der zweiten Seite des Formgehäuses hervorstehen.

Eine Aufgabe der Erfindung ist es, ein verbessertes Leistungsmodul und ein entsprechendes elektrisches Gerät bereitzustellen, welche insbesondere eine niederinduktive Anschlusstechnik ermöglicht.

Eine Lösung der Aufgabe ergibt sich durch ein Leistungsmodul der eingangs genannten Art dadurch, dass der jeweilige, verbleibende der Gleichspannungsanschlüsse zwischen der AC-Anschluss-Seite und der DC-Anschluss-Seite und bei einer Draufsicht im Bereich der Leiterplatte, insb. im Bereich eines Transistor-Moduls des Leistungsmoduls, angeordnet ist.

Weiterhin ergibt sich eine Lösung der Aufgabe durch ein elektrisches Gerät der eingangs genannten Art dadurch, dass das elektrische Gerät zumindest ein solches, vorgeschlagenes Leistungsmodul aufweist.

Ferner ergibt sich eine Lösung der Aufgabe durch ein Ver-fahren zur Herstellung des vorgeschlagenen Leistungsmoduls durch folgende Verfahrensschritte:
- Bereitstellen eines Ausgangs-Leistungsmoduls aufweisend:
   ∘ zumindest einen, an der AC-Anschluss-Seite angeordneten Wechselspannungsanschluss,
   ∘ zwei, an der DC-Anschluss-Seite angeordnete Gleichspannungsanschlüsse,
- Bereitstellen der Leiterplatte zwischen der AC-Anschluss-Seite und der DC-Anschluss-Seite derart, dass einer der mittleren Gleichspannungsanschlüsse und einer der äußeren Gleichspannungsanschlüsse jeweils an der DC-Anschluss-Seite und bei einer Draufsicht außerhalb der Leiterplatte angeordnet sind, und
- Bereitstellen des zumindest einen weiteren Gleichspannungsanschlusses zwischen der AC-Anschluss-Seite und der DC-Anschluss-Seite und bei einer Draufsicht im Bereich der Leiterplatte, insb. im Bereich eines Transistor-Moduls des Leistungsmoduls.

Das vorgeschlagene Leistungsmodul weist eine Leiterplatte auf, die vorzugsweise mit jedem der Gleichspannungsanschlüsse sowie mit jedem der Wechselspannungsanschlüsse elektrisch verbunden ist. Insbesondere kann dem vorgeschlagenen Leistungsmodul auf der einen Seite, der AC-Anschluss-Seite, eine Wechselspannung und auf der gegenüberliegenden Seite, der DC-Anschluss-Seite, eine Gleichspannung zugeführt werden. Bspw. kann die Leiterplatte die Wechselspannung, welche dem Leistungsmodul über den Wechselspannungsanschluss bzw. die Wechselspannungsanschlüsse zuführbar ist, in entsprechende Gleichspannungen wandeln, welche das Leistungsmodul über die Gleichspannungsanschlüsse zur Verfügung stellen kann. Umgekehrt kann die Leiterplatte bspw. die Gleichspannungen, welche dem Leistungsmodul über die Gleichspannungsanschlüsse zuführbar sind, in eine entsprechende Wechselspannung wandeln, welche das Leistungsmodul über den Wechselspannungsanschluss bzw. die Wechselspannungsanschlüsse zur Verfügung stellen kann. Für die erwähnte Spannungswandlung kann das Leistungsmodul bspw. zumindest ein Halbleiter-Bauelement bzw. einen Leistungs-Halbleiter aufweisen, d. h. insb. Bauelemente, die z. B. auf Silizium, Galliumnitrid oder Siliziumcarbid basieren und die in der Leistungselektronik für das Steuern und Schalten hoher elektrischer Ströme und Spannungen ausgelegt sind, d. h. insbesondere Ströme von mehr als 1 Ampere und Spannungen von mehr als etwa 24 Volt. Beispiele solcher Bauelemente sind Leistungsdioden, Thyristoren, Triacs und Transistoren, wie zum Beispiel Leistungs-MOSFETs, IGBTs und dergleichen. Weiterhin kann das Leistungsmodul einen elektrischen Widerstand, bspw. ein Messwiderstand, aufweisen. Vorzugsweise weist das Leistungsmodul dabei einen Transistor, vorzugsweise zumindest zwei Transistoren auf, wobei jeweils zwischen zwei der Gleichspannungsanschlüsse zumindest einer der Transistoren angeordnet sein kann. Der Transistor bzw. die Transistoren kann bzw. können dabei Teil eines Transistor-Moduls des Leistungsmoduls sein.

An der AC-Anschluss-Seite des Leistungsmoduls ist zumindest ein Wechselspannungsanschluss vorgesehen, wobei oftmals zwei solcher Wechselspannungsanschlüsse vorhanden sind, welche üblicherweise mit derselben Wechselspannung versorgt werden. An der DC-Anschluss-Seite des Leistungsmoduls sind zwei Gleichspannungsanschlüsse vorgesehen, nämlich einer der äußeren Gleichspannungsanschlüsse und der mittlere Gleichspannungsanschluss bzw. einer der mittleren Gleichspannungsanschlüsse. Der übrige Gleichspannungsanschluss bzw. die übrigen Gleichspannungsanschlüsse ist bzw. sind zwischen der AC-Anschluss-Seite und der DC-Anschluss-Seite angeordnet, wobei der übrige Gleichspannungsanschluss bzw. die übrigen Gleichspannungsanschlüsse weiterhin bei einer Draufsicht im Bereich der Leiterplatte angeordnet ist bzw. sind. Bei einer Draufsicht wird die Leiterplatte somit von dem übrigen Gleichspannungsanschluss bzw. den übrigen Gleichspannungsanschlüssen zumindest teilweise überdeckt. Während bspw. der jeweilige Wechselspannungsanschluss bzw. die beiden, an der DC-Anschluss-Seite angeordneten Gleichspannungsanschlüsse im Wesentlichen in der Ebene der Leiterplatte und dabei in Verlängerung der Leiterplatte zur AC-Anschluss-Seite bzw. zur DC-Anschluss-Seite angeordnet sein können, ist der jeweilige, verbleibende der Gleichspannungsanschlüsse oberhalb der Leiterplatte angeordnet.

Das Leistungsmodul kann beispielsweise ein oder mehrere Transistor-Module, insb. IGBT-Module, aufweisen, wobei das jeweilige Transistor-Modul einen Transistor umfasst und ggf. weitere Elemente, wie z.B. elektrische Anschlüsse, ein Transistor-Modul-Gehäuse oder einen Transistor-Modul-Kühlkörper, aufweisen kann. Das jeweilige Transistor-Modul kann auf der Leiterplatte angeordnet sein, bspw. auf der Rückseite der Leiterplatte, wenn der übrige Gleichspannungsanschluss bzw. die übrigen Gleichspannungsanschlüsse auf der Vorderseite der Leiterplatte angeordnet ist bzw. sind. Vorzugsweise ist der jeweilige, übrige Gleichspannungsanschluss bei einer Draufsicht im Bereich des jeweiligen Transistor-Moduls angeordnet. Bei einer Draufsicht kann also zunächst der jeweilige, übrige Gleichspannungsanschluss, dann die Leiterplatte und dann das jeweilige Transistor-Modul angeordnet sein. Vorzugsweise ist das das jeweilige Transistor-Modul dabei mit der Leiterplatte und mit dem jeweiligen, übrigen Gleichspannungsanschluss elektrisch verbunden. Durch diese Ausgestaltung des Leistungsmoduls kann ein besonders niederinduktiver Aufbau erzielt werden.

Beispielsweise kann das vorgeschlagene Leistungsmodul quaderförmig ausgestaltet sein, wobei sich die AC-Anschluss-Seite und die DC-Anschluss-Seite gegenüber liegen (bspw. als die Oberseite und die Unterseite des Quaders). Der übrige Gleichspannungsanschluss bzw. die übrigen Gleichspannungsanschlüsse kann bzw. können dann bspw. an einer der Seitenflächen des Quaders angeordnet sein. Das Leistungsmodul kann in manchen Beispielen in etwa die Form eines Domino-Spielsteins haben, welche vergleichsweise dünn und lang sind und eine vergleichsweise große Grundfläche aufweisen. In solchen Beispielen können die AC-Anschluss-Seite und die DC-Anschluss-Seite beispielsweise an den beiden kleinsten Seitenflächen angeordnet sein. Der übrige Gleichspannungsanschluss bzw. die übrigen Gleichspannungsanschlüsse kann bzw. können dann bspw. an den beiden mittelgroßen Seitenflächen angeordnet sein. Bspw. liegt das derart ausgeformte Leistungsmodul an seiner Grundfläche (d.h. einer seiner beiden größten Seitenflächen) auf einem Kühlkörper auf.

Ferner kann das vorgeschlagene Leistungsmodul bspw. genau drei Gleichspannungsanschlüsse aufweisen, nämlich einen positiven Gleichspannungsanschluss, einen mittleren Gleichspannungsanschluss und einen negativen Gleichspannungsanschluss. Bei diesem Beispiel sind der positive Gleichspannungsanschluss und der mittlere Gleichspannungsanschluss an der DC-Anschluss-Seite angeordnet und der negative Gleichspannungsanschluss ist zwischen der AC-Anschluss-Seite und der DC-Anschluss-Seite und bei einer Draufsicht im Bereich der Leiterplatte bzw. des jeweiligen Transistor-Moduls angeordnet. Alternativ kann der negative Gleichspannungsanschluss und der mittlere Gleichspannungsanschluss an der DC-Anschluss-Seite angeordnet sein und der positive Gleichspannungsanschluss ist zwischen der AC-Anschluss-Seite und der DC-Anschluss-Seite und bei einer Draufsicht im Bereich der Leiterplatte bzw. des jeweiligen Transistor-Moduls angeordnet, sodass der negative Gleichspannungsanschluss und der positive Gleichspannungsanschluss vertauscht sind. Wenn das vorgeschlagene Leistungsmodul genau drei Gleichspannungsanschlüsse aufweist, lassen sich 3-Level-Anwendungen realisieren, welche ja drei unterschiedliche Gleichspannungspotenziale aufweisen.

Darüber hinaus kann das vorgeschlagene Leistungsmodul auch vier oder mehr Gleichspannungsanschlüsse aufweisen, nämlich einen positiven Gleichspannungsanschluss, zwei oder mehr mittlere Gleichspannungsanschlüsse und einen negativen Gleichspannungsanschluss. Bei diesem Beispiel sind der positive Gleichspannungsanschluss und einer der mittleren Gleichspannungsanschlüsse an der DC-Anschluss-Seite angeordnet. Der negative Gleichspannungsanschluss sowie der übrige mittlere Gleichspannungsanschluss bzw. die übrigen mittleren Gleichspannungsanschlüsse sind zwischen der AC-Anschluss-Seite und der DC-Anschluss-Seite und bei einer Draufsicht im Bereich der Leiterplatte bzw. des jeweiligen Transistor-Moduls angeordnet. Wenn das vorgeschlagene Leistungsmodul genau vier oder mehr Gleichspannungsanschlüsse aufweist, lassen sich Anwendungen mit 4 oder mehr Leveln bzw. Gleichspannungspotentialen realisieren.

Von besonderem Vorteil ist bei dem vorgeschlagenen Leistungsmodul dabei, dass ein niederinduktiver Aufbau realisiert werden kann. Dies wird insb. dadurch erreicht, dass die beiden äußeren Gleichspannungsanschlüsse vergleichsweise nahe beieinander angeordnet sind. Beispielsweise werden die Gleichspannungsanschlüsse DCP, DCM, DCN bei einem Einsatz des Leistungsmoduls in einem 3-Level-Umrichter als Zwischenkreis-Anschlüsse DCP-DCM-DCN nahe beieinander angeordnet, was dazu bspw. beiträgt, das Schaltverhalten der im Umrichter oder im Leistungsmodul vorhandenen Leistungsschalter wesentlich zu verbessern und somit die Verlustleistungen von Leistungshalbleitern deutlich zu reduzieren.

Weiterhin kann das Leistungsmodul ein Gehäuse aufweisen, welches die Leiterplatte und ggf. weitere Bestandteile des Leistungsmoduls zumindest teilweise einhaust.

Die Gleichspannungsanschlüsse und die Wechselspannungsanschlüsse können jeweils bspw. als Schraubanschluss ausgeführt sein.

Bei einer vorteilhaften Ausgestaltung der Erfindung ist der jeweilige mittlere Gleichspannungsanschluss zwischen dem positiven Gleichspannungsanschluss und dem negativen Gleichspannungsanschluss angeordnet.

Besonders gute Ergebnisse bezüglich eines niederinduktiven Aufbaus lassen sich dadurch realisieren, dass der jeweilige mittlere Gleichspannungsanschluss zwischen den beiden äußeren Gleichspannungsanschlüssen angeordnet ist. Bspw. sind bei einer Draufsicht auf das Leistungsmodul im Uhrzeigersinn oder entgegen dem Uhrzeigersinn zunächst der negative Gleichspannungsanschluss, dann der mittlere Gleichspannungsanschluss bzw. die mittleren Gleichspannungsanschlüssen, und schließlich der positive Gleichspannungsanschluss angeordnet.

Wenn mehr als ein mittlerer Gleichspannungsanschluss vorhanden ist, sind die mittleren Gleichspannungsanschlüsse vorzugsweise gemäß ihrem jeweiligen, vorgesehenen elektrischen Potenzial aufsteigend vom negativen Gleichspannungsanschluss zum positiven Gleichspannungsanschluss bzw. absteigend vom positiven Gleichspannungsanschluss zum negativen Gleichspannungsanschluss angeordnet.

Beispielsweise sind die Gleichspannungsanschlüsse jeweils im Wesentlichen äquidistant zueinander angeordnet. Bei einem Leistungsmodul mit drei Gleichspannungsanschlüssen ist der mittlere Gleichspannungsanschluss somit im Wesentlichen gleich weit vom positiven Gleichspannungsanschluss wie vom negativen Gleichspannungsanschluss entfernt. Dies bedeutet, dass der mittlere Gleichspannungsanschluss im Wesentlichen mittig zwischen dem positiven Gleichspannungsanschluss und dem negativen Gleichspannungsanschluss angeordnet ist. Dabei können Abweichungen von der Äquidistanz von bspw. ±20% bzw. ±10% noch akzeptabel sein.

Besonders vorteilhaft ist eine Ausgestaltung des Leistungsmodul gemäß welcher die beiden äußeren Gleichspannungsanschlüsse vergleichsweise nah beieinander angeordnet sind, wobei der mittlere Gleichspannungsanschluss bzw. die mittleren Gleichspannungsanschlüsse mittig angeordnet ist bzw. sind. Damit kann das Schaltverhalten der im Umrichter oder im Leistungsmodul ggf. vorhandenen Leistungsschalter weiter verbessert werden und somit können die Verlustleistungen von Leistungshalbleitern weiter reduziert werden.

Bei einer weiteren vorteilhaften Ausgestaltung der Erfindung weist die Leiterplatte zwischen der AC-Anschluss-Seite und der DC-Anschluss-Seite zumindest einen aus der Leiterplatte herausragenden Anschlusspin auf, wobei der jeweilige, verbleibende der Gleichspannungsanschlüsse mit dem jeweiligen Anschlusspin elektrisch verbunden ist.

Bspw. ragt der jeweilige Anschlusspin aus der Ebene der flacheren Leiterplatte senkrecht heraus und ist dabei zwischen der AC-Anschluss-Seite und der DC-Anschluss-Seite angeordnet. Damit kann der jeweilige, verbleibende der Gleichspannungsanschlüsse bei einer Draufsicht im Bereich der Leiterplatte bzw. des jeweiligen Transistor-Moduls angeordnet werden, indem der jeweilige, verbleibende der Gleichspannungsanschlüsse mit dem jeweiligen Anschlusspin elektrisch verbunden wird. Bei einigen Beispielen können dabei auch zwei oder mehr Anschlusspins pro jeweiligem, verbleibenden Gleichspannungsanschluss vorgesehen sein, womit größere Ströme ermöglicht werden können. Weiterhin können zwei oder mehr der verbleibenden Gleichspannungsanschlüsse vorgesehen sein, welche über einen oder mehrere jeweilige Anschlusspins mit der Leiterplatte verbunden sind. Durch diese Ausgestaltung des Leistungsmoduls lassen sich die bereits oben erwähnten Anwendungen mit 4 oder mehr Leveln bzw. Gleichspannungspotentialen realisieren.

Bspw. kann der jeweilige Anschlusspin ein Anschlusspin eines Transistors bzw. des o.g. Transistor-Moduls sein, welcher bzw. welches auf der Leiterplatte bzw. auf der Rückseite der Leiterplatte, angeordnet ist.

Bei einer weiteren vorteilhaften Ausgestaltung der Erfindung weist das Leistungsmodul dabei weiterhin eine jeweilige Leiterfläche auf, wobei die jeweilige Leiterfläche zwischen dem jeweiligen Anschlusspin und dem jeweiligen, verbleibenden der Gleichspannungsanschlüsse angeordnet ist, und wobei der jeweilige Anschlusspin und der jeweilige, verbleibende der Gleichspannungsanschlüsse mit der jeweiligen Leiterfläche elektrisch verbunden ist.

Die jeweilige Leiterfläche kann bspw. als flache Platte eines elektrisch leitenden Materials, bspw. Kupfer oder Aluminium, oder auch als DCB (Direct Copper Bonded) ausgestattet sein, und ist mit dem jeweiligen Anschlusspin und mit dem jeweiligen, verbleibenden der Gleichspannungsanschlüsse elektrisch verbunden. Durch die jeweilige Leiterfläche wird die elektrische Verbindung des jeweiligen Anschlusspins mit dem jeweiligen, verbleibenden der Gleichspannungsanschlüsse erleichtert und zusätzlich mechanisch robuster ausgestaltet. Bei zwei oder mehr der verbleibenden Gleichspannungsanschlüssen ist dabei zumindest eine Leiterfläche pro verbleibendem Gleichspannungsanschluss vorgesehen.

Die jeweilige Leiterfläche kann bspw., abgesehen von der Befestigung über den jeweiligen Anschlusspin, zusätzlich an der Leiterplatte und/oder an einem eventuell vorhandenen Gehäuse des Leistungsmoduls befestigt sein.

Bei einer weiteren vorteilhaften Ausgestaltung der Erfindung ist dabei die jeweilige Leiterfläche parallel zur Leiterplatte angeordnet, wobei alternativ oder zusätzlich die Leiterplatte bei einer Draufsicht die jeweilige Leiterfläche vollständig überdeckt.

Durch die Anordnung der jeweiligen Leiterfläche parallel zur Leiterplatte ergibt sich ein kompakter und stabiler Aufbau, der weiterhin eine niederinduktive Anschlusstechnik unterstützt. Ein kompakter Aufbau wird auch unterstützt, dass die Leiterplatte die jeweilige Leiterfläche vollständig überdeckt, wobei vorzugsweise der jeweilige Anschlusspin bei einer Draufsicht auf die Leiterplatte von der jeweiligen Leiterfläche abgedeckt wird.

Bei einer weiteren vorteilhaften Ausgestaltung der Erfindung weist das Leistungsmodul weiterhin zumindest zwei Kondensatoren auf, wobei einer der Kondensatoren mit dem einen der äußeren Gleichspannungsanschlüsse und einem der mittleren Gleichspannungsanschlüsse elektrisch verbunden ist und wobei ein anderer der Kondensatoren mit dem anderen der äußeren Gleichspannungsanschlüsse und einem der mittleren Gleichspannungsanschlüsse elektrisch verbunden ist, und wobei die elektrische Verbindung zwischen dem jeweiligen Kondensator und dem jeweiligen Gleichspannungsanschluss höchstens zwei Mal so lang, insbesondere höchstens genauso lang oder höchstens halb so lang, ist wie der Abstand zwischen den beiden äußeren Gleichspannungsanschlüssen.

Bei einer Ausgestaltung des vorgeschlagenen Leistungsmoduls mit drei Gleichspannungsanschlüssen, d.h. passend für 3-Level-Anwendungen, sind zumindest zwei Kondensatoren vorgesehen, wobei der eine Kondensator mit dem positiven Gleichspannungsanschluss und dem mittleren Gleichspannungsanschluss und der andere Kondensator mit dem mittleren Gleichspannungsanschluss und dem negativen Gleichspannungsanschluss elektrisch verbunden ist. Entsprechend sind bei einer Ausgestaltung des vorgeschlagenen Leistungsmoduls mit vier oder mehr Gleichspannungsanschlüssen, d.h. passend für Anwendungen mit 4 oder mehr Leveln bzw. Gleichspannungspotentialen, zumindest drei oder entsprechend mehr Kondensatoren vorgesehen, wobei der eine Kondensator mit dem positiven Gleichspannungsanschluss und dem mittleren Gleichspannungsanschluss des zweitgrößten elektrischen Potentials elektrisch verbunden ist, wobei der nächste Kondensator mit den mittleren Gleichspannungsanschlüssen des zweitgrößten elektrischen Potentials und des drittgrößten elektrischen Potentials elektrisch verbunden ist, usw., bis schließlich der letzte Kondensator mit dem mittleren Gleichspannungsanschluss des zweitniedrigsten elektrischen Potentials und mit dem negativen Gleichspannungsanschluss elektrisch verbunden ist. Prinzipiell können dabei auch zwei oder mehr Kondensatoren in Reihe oder parallel zueinander zwischen den genannten Paaren von Gleichspannungsanschlüssen angeordnet sein.

Ein besonders niederinduktiver Aufbau lässt sich dabei dadurch erreichen, dass die elektrische Verbindung zwischen dem jeweiligen Kondensator und dem jeweiligen Gleichspannungsanschluss möglichst kurz ausgestaltet wird, vorteilhafterweise höchstens zwei Mal so lang, insbesondere höchstens genauso lang oder höchstens halb so lang, ist wie der Abstand zwischen den beiden äußeren Gleichspannungsanschlüssen. In einigen Beispielen kann die genannte Verbindung auch höchstens zwei Mal so lang, insbesondere höchstens genauso lang oder höchstens halb so lang, sein wie der Abstand zwischen den Gleichspannungsanschlüssen des jeweiligen, genannten Paars von Gleichspannungsanschlüssen.

Bei einer weiteren vorteilhaften Ausgestaltung der Erfindung weist das Leistungsmodul dabei weiterhin eine Kondensatorplatte auf, auf welcher der jeweilige Kondensator angeordnet ist, wobei die Kondensatorplatte vorzugsweise parallel zur Leiterplatte angeordnet ist, und wobei der jeweilige Kondensator auf der Kondensatorplatte insbesondere innerhalb eines Rechteckes angeordnet ist, welches bei einer Draufsicht von den Gleichspannungsanschlüssen begrenzt wird und welches parallel zur Leiterplatte ausgerichtet ist.

Bspw. kann die Kondensatorplatte als weitere Leiterplatte ausgestaltet sein. Auf der Kondensatorplatte sind die Kondensatoren angeordnet, wobei die Kondensatoren wie oben beschrieben mit den Gleichspannungsanschlüssen elektrisch verbunden sind. Ein einfacher und gleichermaßen robuster Aufbau des Leistungsmoduls kann insbesondere dadurch erreicht werden, dass die Kondensatorplatte parallel zur Leiterplatte angeordnet ist und sich die Kondensatorplatte dabei bspw. auf der Oberseite der Leiterplatte befindet. Weiterhin lässt sich ein kompakter und besonders niederinduktiver Aufbau des Leistungsmoduls dadurch erreichen, dass die Kondensatorplatte im Bereich der Gleichspannungsanschlüsse bzw. des jeweiligen Transistor-Moduls angeordnet ist, sodass der jeweilige Kondensator ebenfalls in der Nähe bzw. im Bereich der Gleichspannungsanschlüsse angeordnet ist. Üblicherweise sind die Gleichspannungsanschlüssen dabei derart angeordnet, dass sie bei einer Draufsicht auf die Leiterplatte ein Rechteck begrenzen bzw. von einem Rechteck eingefasst werden können, wobei vorzugsweise das kleinstmögliche, derartige Rechteck betrachtet wird. Vorzugsweise ist der jeweilige Kondensator auf der Kondensatorplatte dann innerhalb dieses Rechteckes angeordnet, wodurch kurze elektrische Verbindungswege zwischen dem jeweiligen Gleichspannungsanschluss und dem jeweiligen Kondensator und somit insgesamt ein niederinduktiver Aufbau des Leistungsmoduls realisierbar sind.

In manchen Beispielen ist die die elektrische Verbindung zwischen dem jeweiligen Kondensator und dem jeweiligen Gleichspannungsanschluss dabei höchstens zwei Mal so lang, insbesondere höchstens genauso lang oder höchstens halb so lang, ist wie der Abstand zwischen den beiden äußeren Gleichspannungsanschlüssen.

Insbesondere sind zumindest die Hälfte der Kondensatoren des Leistungsmoduls, vorzugsweise drei Viertel oder alle der Kondensatoren des Leistungsmoduls, in dem genannten Rechteck angeordnet bzw. über die genannte elektrische Verbindung mit dem jeweiligen Gleichspannungsanschluss elektrisch verbunden.

Die Kondensatorplatte kann bspw. an der Leiterplatte und/oder an einem eventuell vorhandenen Gehäuse des Leistungsmoduls befestigt sein.

Bei einer weiteren vorteilhaften Ausgestaltung der Erfindung weist das Leistungsmodul weiterhin eine jeweilige Stromschiene auf, welche mit dem jeweiligen Gleichspannungsanschluss und optional mit dem jeweiligen Kondensator elektrisch verbunden ist, wobei die Stromschienen zumindest überwiegend parallel zueinander angeordnet sind, und wobei die jeweilige Stromschiene des jeweiligen mittleren Gleichspannungsanschlusses zwischen den Stromschienen der beiden äußeren Gleichspannungsanschlüsse angeordnet ist.

Pro Gleichspannungsanschluss kann somit je eine Stromschiene vorgesehen sein, wobei die Stromschienen zumindest auf der Hälfte ihrer Länge parallel zueinander geführt werden. Vorzugsweise werden die Stromschienen weit überwiegend, bspw. zumindest auf drei Vierteln oder 90 % ihrer Länge parallel zueinander geführt. Insbesondere können die Stromschienen dabei äquidistant zueinander angeordnet sein, d. h. bei einem Leistungsmodul mit drei Stromschienen, dass die Stromschiene des mittleren elektrischen Potenzials in der Mitte zwischen den Stromschienen des negativen und des positiven elektrischen Potenzials angeordnet ist, wobei Abweichungen von ±5% bis zu ±10% noch akzeptabel sein können und wobei die äquidistante Anordnung der Stromschienen bspw. auf der oben genannten Länge, d. h. mindestens 50%, 75% oder 90% der Länge der Stromschienen, vorgesehen sein kann. Wenn mehr als ein mittlerer Gleichspannungsanschluss vorhanden ist, haben zwei benachbarte Stromschienen somit vorzugsweise jeweils denselben Abstand zueinander, wobei die Äquidistanz ebenfalls die genannten Abweichungen aufweisen bzw. über die genannte Länge vorliegen kann. Die parallele bzw. äquidistante Führung der Stromschienen trägt dabei zu einem niederinduktiven Aufbau des Leistungsmoduls bei.

Der niederinduktive Aufbau des Leistungsmoduls wird weiterhin dadurch unterstützt, dass die Stromschiene des mittleren Gleichspannungsanschlusses bzw. die Stromschienen der mittleren Gleichspannungsanschlüsse zwischen den Stromschienen der beiden äußeren Gleichspannungsanschlüssen angeordnet ist bzw. sind. Wenn mehr als ein mittlerer Gleichspannungsanschluss vorhanden ist, sind die Stromschienen der mittleren Gleichspannungsanschlüsse vorzugsweise gemäß ihrem jeweiligen, vorgesehenen elektrischen Potenzial aufsteigend vom negativen Gleichspannungsanschluss zum positiven Gleichspannungsanschluss bzw. absteigend vom positiven Gleichspannungsanschluss zum negativen Gleichspannungsanschluss angeordnet.

Weiterhin kann die jeweilige Stromschiene einen rechteckigen Querschnitt aufweisen, wobei die lange oder die kurze Seite des Rechtecks vorzugsweise im Wesentlichen senkrecht zur Ebene der Leiterplatte ausgerichtet ist. Dies ermöglicht einen kompakten Aufbau des Leistungsmoduls.

Bei einer weiteren vorteilhaften Ausgestaltung der Erfindung weist das Leistungsmodul weiterhin zumindest einen Snubber-Kondensator auf, wobei der jeweilige Snubber-Kondensator auf der Leiterplatte angeordnet ist, wobei der jeweilige Snubber-Kondensator mit dem jeweiligen Gleichspannungsanschluss elektrisch verbunden ist, und wobei die elektrische Verbindung zwischen dem jeweiligen Snubber-Kondensator und dem jeweiligen Gleichspannungsanschluss höchstens zwei Mal so lang, insbesondere höchstens genauso lang oder höchstens halb so lang, ist wie der Abstand zwischen den beiden äußeren Gleichspannungsanschlüssen.

Der jeweilige Snubber-Kondensator trägt ebenfalls zu einem niederinduktiven Aufbau des Leistungsmoduls bei, wozu der jeweilige Snubber-Kondensator hierzu recht nahe an dem jeweiligen Gleichspannungsanschluss angeordnet ist und mit diesem elektrisch verbunden ist. Darüber hinaus ist der jeweilige Snubber-Kondensator mit einem passenden elektrischen Potenzial elektrisch verbunden.

Bei einer weiteren vorteilhaften Ausgestaltung der Erfindung ist das Leistungsmodul mit einer elektrischen Leistung von zumindest mehreren 10 kW, vorzugsweise 40 kW bis 500 kW, mit einer Wechselspannung von zumindest mehreren 100 V, vorzugsweise 280 V bis 800 V, mit einer Gleichspannung von zumindest mehreren 100 V, vorzugsweise 800 V bis 1500 V, und/oder elektrischen Strömen von mehreren 10 A, vorzugsweise 70 A bis 1000 A, betreibbar.

Bei einer weiteren vorteilhaften Ausgestaltung der Erfindung weist das Leistungsmodul eine Grundfläche von 80 cm² bis 100 cm² auf, wobei die Grundfläche insbesondere rechteckig ist mit einer Seitenlänge von ca. 150 mm an seiner langen Seite und mit einer Seitenlänge von ca. 62,5 mm an seiner kurzen Seite.

Bei einer weiteren vorteilhaften Ausgestaltung der Erfindung weist das elektrische Gerät eine Grundplatte und zumindest zwei der vorgeschlagenen Leistungsmodule auf, wobei die Leistungsmodule derart nebeneinander auf der Grundplatte angeordnet sind, dass die DC-Anschluss-Seiten der Leistungsmodule in dieselbe Richtung weisen, weiterhin aufweisend eine jeweilige Geräte-Stromschiene, welche mit dem jeweiligen Gleichspannungsanschluss (DCP, DCM, DCN) des jeweiligen Leistungsmoduls und optional mit dem jeweiligen Kondensator elektrisch verbunden ist, und wobei die Geräte-Stromschienen zumindest abschnittsweise parallel zueinander angeordnet sind.

Bspw. kann die jeweilige Geräte-Stromschiene einstückig mit der jeweiligen, entsprechenden Stromschiene des einzelnen Leistungsmoduls ausgeführt sein. Die Gleichspannungsanschlüsse der Leistungsmodule mit demselben elektrischen Potenzial können somit mit einer jeweiligen Geräte-Stromschiene verbunden sein, wobei die jeweilige, entsprechende Stromschiene des einzelnen Leistungsmoduls Teil der entsprechenden Geräte-Stromschienen sein kann. Indem die Leistungsmodule derart angeordnet sind, dass ihre jeweilige DC-Anschluss-Seite in dieselbe Richtung weist, werden vergleichsweise kurze, jeweilige Geräte-Stromschienen ermöglicht, was zu einem niederinduktiven Aufbau des elektrischen Gerätes beiträgt. Diese Anordnung wird beispielsweise dadurch erreicht, dass die Leistungsmodule in einer Reihe nebeneinander angeordnet werden.

Wie oben bereits für das jeweilige Leistungsmodul bezüglich der jeweiligen Stromschiene ausgeführt, können auch die jeweilige Geräte-Stromschiene zumindest auf der Hälfte ihrer Länge parallel bzw. äquidistant zueinander geführt werden, wobei die oben erläuterten Abweichungen auch bezüglich der Geräte-Stromschienen noch akzeptabel sein können. Die parallele bzw. äquidistante Führung der Geräte-Stromschienen trägt dabei wiederum zu einem niederinduktiven Aufbau des elektrischen Gerätes bei. Vorzugsweise sind die Geräte-Stromschienen weiterhin gemäß ihrem elektrischen Potenzial aufsteigend vom negativen Gleichspannungsanschluss zum positiven Gleichspannungsanschluss bzw. absteigend vom positiven Gleichspannungsanschluss zum negativen Gleichspannungsanschluss angeordnet.

Vorzugsweise weist das elektrische Gerät dabei zumindest drei solcher Leistungsmodule auf, wobei dem elektrischen Gerät ein dreiphasiger Wechselstrom zuführbar ist und dabei das jeweilige Leistungsmodul eine der drei Phasen des Wechselstroms aufnimmt.

Bei dem vorgeschlagenen Verfahren ist von besonderem Vorteil, dass bspw. kostengünstig erhältliche herkömmliche Leistungsmodule, welche insbesondere für 2-Level-Anwendungen konzipiert sind, als Ausgangs-Leistungsmodule verwendet werden können. Ein solches herkömmliches Leistungsmodul kann bspw. lediglich zumindest einen Wechselspannungsanschluss an der AC-Anschluss-Seite sowie zwei Gleichspannungsanschlüsse an der DC-Anschluss-Seite aufweisen. Solche herkömmliche Leistungsmodul sind bspw. aus der bereits oben genannten US8847328B1 bekannt, welche vier Leistungsanschlüsse aufweisen, nämlich zwei Wechselspannungsanschlüsse und diesen gegenüber liegend angeordnet zwei Gleichspannungsanschlüsse. Ein solches herkömmliches Leistungsmodul kann dabei auch ohne eigene Leiterplatte als Ausgangs-Leistungsmodul des vorgeschlagenen Verfahrens dienen. Insbesondere kann das Ausgangs-Leistungsmodul das Gehäuse und bspw. die vorhandenen (Schraub-)Anschlüsse des herkömmlichen Leistungsmoduls aufweisen.

Ein solches Ausgangs-Leistungsmodul wird dann mit der für das vorgeschlagene Leistungsmodul passenden Leiterplatte ausgerüstet, wobei die Leiterplatte derart angeordnet wird, dass einer der mittleren Gleichspannungsanschlüsse und einer der äußeren Gleichspannungsanschlüsse jeweils an der DC-Anschluss-Seite und bei einer Draufsicht außerhalb der Leiterplatte angeordnet sind. Das Ausgangs-Leistungsmodul wird weiterhin mit zumindest einem weiteren Gleichspannungsanschluss ausgerüstet, welcher jeweils zwischen der AC-Anschluss-Seite und der DC-Anschluss-Seite und bei einer Draufsicht im Bereich der Leiterplatte bzw. des jeweiligen Transistor-Moduls angeordnet ist.

Vorzugsweise wird zusätzlich eine jeweilige elektrische Verbindung des jeweiligen Wechselspannungsanschlusses und des jeweiligen Gleichspannungsanschlusses mit der Leiterplatte hergestellt.

Wie oben bereits erwähnt, kann das Ausgangs-Leistungsmodul insbesondere das Gehäuse und bspw. die vorhandenen (Schraub-) Anschlüsse des herkömmlichen Leistungsmoduls aufweisen, wobei dann im Rahmen des vorgeschlagenen Verfahrens die Leiterplatte sowie der zusätzliche Gleichspannungsanschluss bzw. die zusätzlichen Gleichspannungsanschlüsse bereitgestellt und angebracht werden und wobei bspw. die Anordnung der Transistoren bzw. IGBTs zusätzlich geändert bzw. neu bereitgestellt wird.

Von besonderem Vorteil ist bei dem vorgeschlagenen Leistungsmodul bzw. elektrischen Gerät und insbesondere bei dem vorgeschlagenen Verfahren, dass bspw. ein niederinduktiver Aufbau anhand von herkömmlichen Leistungsmodulen bzw. IGBT-Modulen mit Schraubanschlüssen erreicht werden kann, ohne das Modulgehäuse des herkömmlichen Leistungsmoduls massiv anzupassen. Dabei wird insb. eine spezielle Anordnung der Anschluss-technik für 3-level-Anwendungen vorgeschlagen, welche einen niederinduktiven Aufbau in bestehenden, herkömmlichen Modulgehäusen erlaubt. Als Basis für eine 3-Level-Anwendung bzw. für ein 3-Level-fähiges Leistungsmodul kann bspw. ein vorhandenes 2-Level-IGBT-Modulgehäuse mit lediglich anders angeordneten Einlöt- bzw. Einpresspins dienen.

Bspw. werden die Leistungsschraubanschlüsse unverändert herausgeführt, jedoch intern anders angeschlossen. So können die Pins 10 und 11 weiterhin als Wechselspannungsanschlüsse herausgeführt werden, wobei Pin 4 als positiver Gleichspannungsanschluss, Pin 3 als mittlerer Gleichspannungsanschluss und der negative Gleichspannungsanschluss über die seitlichen Einlöt- bzw. Einpresspins herausgeführt werden kann. Über diese seitlichen Pins, welche an die Leiterplatte angeschlossen sind, kann der Strom über einen auf der Leiterplatte montierten (bspw. gelöteten oder eingepressten) Schraubanschluss abgegriffen werden. Weiterhin kann der positive Gleichspannungsanschluss und der negative Gleichspannungsanschluss wahlweise getauscht werden. Für einen möglichst niederinduktiven Aufbau des Leistungsmoduls ist der mittlere Gleichspannungsanschluss vorzugsweise mittig angeordnet. So entsteht durch eine Verbindung des Ausgangs-Leistungsmoduls, der Leiterplatte und des externen Schraubanschlusses ein vollwertiges, niederinduktives 3-Level-Leistungsodul, welches zu minimalem Kosteneinsatz appliziert werden kann. Es können verschiedene Stromschienen-Varianten appliziert werden, hochkant-stehend oder flach übereinander angeordnet. Für Anwendungen mit mehr als drei Gleichspannungspotenzialen werden ein entsprechendes Leistungsmodul bzw. ein entsprechendes Herstellungsverfahren vorgeschlagen.

Diese vorgeschlagene, spezielle kompakte Kombination hat entscheidende Vorteile gegenüber der herkömmlichen Anschlusstechnik bei Leistungsmodulen, insb. IGBT-Modulen: Bspw. ist diese Applikation optimal geeignet für 3-Level-Anwendungen, aber auch für Anwendungen mit 4 oder mehr Leveln bzw. Gleichspannungspotentialen. Dabei wird insbesondere eine niederinduktive Anschlusstechnik bei dem Leistungsmodul erreicht. Weiterhin ermöglicht das vorgeschlagene Leistungsmodul bzw. Verfahren, bestehende IGBT-Modulgehäuse bzw. Ausgangs-Leistungsmodule wiederzuverwenden. Es wird dabei eine kompakte Anschlusstechnik vorgeschlagen, welche nicht das IGBT-Modulgehäuse übersteigt bzw. mehr Bauraum als das IGBT-Modulgehäuse bzw. das Ausgangs-Leistungsmodul benötigt. Besonders geeignet ist das vorgeschlagene Verfahren insbesondere für geringe Stückzahlen, da keine Investitionen in neues 3-Level-Gehäuse erforderlich sind. Dies trifft gleichermaßen auch für Universal-Gehäuse mit wahlweise steckbaren Einlöt- bzw. Einpresspins zu. Darüber hinaus können weiterer Bauelemente, wie z.B. Snubber, nah an den IGBT- bzw. Gleichspannungsanschlüssen angeordnet werden. Der vorgeschlagene Aufbau des Leistungsmoduls ist dabei sehr kompakt verglichen mit alternativen Lösungen und nimmt bspw. nur 93,8cm² Grundfläche ein. Diese vergleichsweise kleine Grundfläche kann für den Einsatz in kompakten Frequenzumrichtern entscheidend sein.

Im Folgenden wird die Erfindung anhand der in den Figuren dargestellten Ausführungsbeispiele näher beschrieben und erläutert. Es zeigen:
- FIG 1-8: ein erstes bis achtes Ausführungsbeispiel des vorgeschlagenen Leistungsmoduls,
- FIG 9: ein Ausführungsbeispiel des vorgeschlagenen elektrischen Geräts und
- FIG 10: ein Ablaufschema eines Ausführungsbeispiels des vorgeschlagenen Verfahrens zur Herstellung eines Ausführungsbeispiels eines Leistungsmoduls.

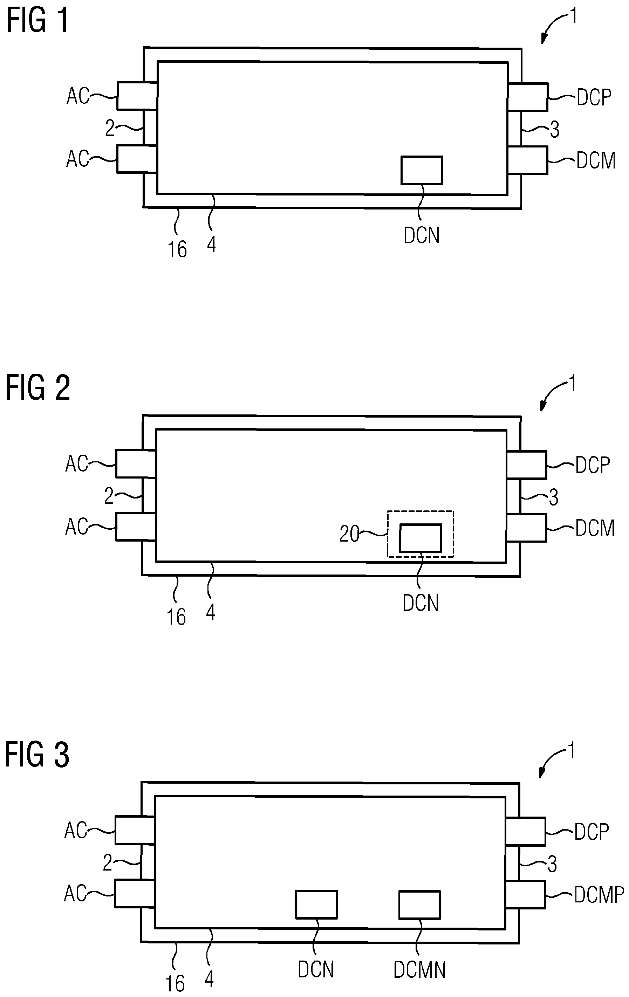

Die Figur 1 zeigt ein erstes Ausführungsbeispiel des vorgeschlagenen Leistungsmoduls 1, wobei eine schematische Ansicht dargestellt ist.

Das Leistungsmodul 1 weist eine AC-Anschluss-Seite 2 und eine, der AC-Anschluss-Seite 2 gegenüberliegende DC-Anschluss-Seite 3 sowie eine Leiterplatte 4 auf. Weiterhin weist das Leistungsmodul zwei an der AC-Anschluss-Seite 2 angeordnete Wechselspannungsanschlüsse AC auf sowie drei Gleichspannungsanschlüsse DCP, DCM, DCN auf. Von den drei Gleichspannungsanschlüsse DCP, DCM, DCN sind der mittlere Gleichspannungsanschluss DCM sowie der positive Gleichspannungsanschluss DCP an der DC-Anschluss-Seite 3 und bei einer Draufsicht außerhalb der Leiterplatte 4 angeordnet. Der dritte der drei Gleichspannungsanschlüsse DCP, DCM, DCN ist der negative Gleichspannungsanschluss DCN, welcher zwischen der AC-Anschluss-Seite 2 und der DC-Anschluss-Seite 3 und bei einer Draufsicht im Bereich der Leiterplatte 4 angeordnet ist. Dabei bilden der positive Gleichspannungsanschluss DCP und der negative Gleichspannungsanschluss DCN die beiden äußeren Gleichspannungsanschlüsse DCP, DCN.

Die beiden Wechselspannungsanschlüsse AC und die beiden, an der DC-Anschluss-Seite angeordneten Gleichspannungsanschlüsse, nämlich der mittlere Gleichspannungsanschluss DCM sowie der positive Gleichspannungsanschluss DCP, sind dabei im Wesentlichen in der Ebene der Leiterplatte 4 und dabei in Verlängerung der Leiterplatte 4 zur AC-Anschluss-Seite 2 bzw. zur DC-Anschluss-Seite 3 angeordnet. Der negative Gleichspannungsanschluss DCN hingegen ist oberhalb der Leiterplatte 4 und zwischen AC-Anschluss-Seite 2 und der DC-Anschluss-Seite 3 angeordnet.

Weiterhin weist das Leistungsmodul ein Gehäuse 16 auf, welches die Leiterplatte 4 zumindest teilweise einhaust.

Vorzugsweise, und wie in Figur 1 dargestellt, ist der mittlere Gleichspannungsanschluss DCM zwischen dem positiven Gleichspannungsanschluss DCP und dem negativen Gleichspannungsanschluss DCN angeordnet ist. Beispielsweise sind die Gleichspannungsanschlüsse DCP, DCM, DCN jeweils im Wesentlichen äquidistant zueinander angeordnet.

Das in Figur 1 dargestellte Leistungsmodul 1 weist dabei genau drei Gleichspannungsanschlüsse DCP, DCM, DCN auf, so dass sich damit 3-Level-Anwendungen realisieren lassen.

Die Figur 2 zeigt ein zweites Ausführungsbeispiel des vor-geschlagenen Leistungsmoduls 1, wobei wiederum eine schematische Ansicht dargestellt ist. Gleiche Bezugszeichen wie in Figur 1 bezeichnen dabei gleiche Gegenstände. Da das zweite Ausführungsbeispiel einige Ähnlichkeiten mit dem ersten Ausführungsbeispiel aufweist, werden im Folgenden einige Unterschiede erläutert.

Das Leistungsmodul weist weiterhin ein Transistor-Modul 20 auf, welches bei einer Draufsicht auf die Leiterplatte 4 hinter der Leiterplatte 4 angeordnet ist. Bei einer Draufsicht auf das Leistungsmodul 1 ist also zunächst der Gleichspannungsanschluss DCN, dann die Leiterplatte 4 und dann das Transistor-Modul 20 angeordnet. Der Gleichspannungsanschluss DCN ist dabei zwischen der AC-Anschluss-Seite 2 und der DC-Anschluss-Seite 3 und bei einer Draufsicht im Bereich des Transistor-Moduls 20 des Leistungsmoduls 1 angeordnet.

Ein solches, jeweiliges Transistor-Modul 20 kann bspw. auch bei den übrigen Ausführungsbeispielen des vorgeschlagenen Leistungsmoduls 1 vorgesehen sein, wobei der jeweilige, übrige Gleichspannungsanschluss dann zwischen der AC-Anschluss-Seite 2 und der DC-Anschluss-Seite 3 und bei einer Draufsicht im Bereich des (jeweiligen) Transistor-Moduls 20 des Leistungsmoduls 1 angeordnet ist.

Die Figur 3 zeigt ein drittes Ausführungsbeispiel des vor-geschlagenen Leistungsmoduls 1, wobei wiederum eine Draufsicht dargestellt ist. Da das dritte Ausführungsbeispiel einige Ähnlichkeiten mit dem ersten Ausführungsbeispiel aufweist, werden im Folgenden einige Unterschiede erläutert.

Das in Figur 3 dargestellte Leistungsmodul 1 weist vier Gleichspannungsanschlüsse DCP, DCMP, DCMN, DCN auf, nämlich den positiven Gleichspannungsanschluss DCP, nun jedoch zwei mittlere Gleichspannungsanschlüsse DCMP und DCMN und den negativen Gleichspannungsanschluss DCN. Vorzugsweise sind die vier Gleichspannungsanschlüsse DCP, DCMP, DCMN, DCN für entsprechende elektrische Potentiale ausgelegt, die im Wesentlichen äquidistant zueinander sind, so dass der Potentialunterschied zwischen den Paaren der Gleichspannungsanschlüsse DCP-DCMP, DCMP-DCMN, und DCMN-DCN im Wesentlichen gleich ist. Wie in Figur 3 dargestellt, sind bei diesem Leistungsmodul 1 der positive Gleichspannungsanschluss und der mittlere Gleichspannungsanschluss DCMP an der DC-Anschluss-Seite 3 angeordnet. Der negative Gleichspannungsanschluss DCN sowie der mittlere Gleichspannungsanschluss DCMN sind zwischen der AC-Anschluss-Seite 2 und der DC-Anschluss-Seite 3 und bei einer Draufsicht im Bereich der Leiterplatte 4 angeordnet. Mit den vier Gleichspannungsanschlüssen DCP, DCMP, DCMN, DCN lassen sich 4-Level-Anwendungen realisieren.

Vorzugsweise, und wie in Figur 3 dargestellt, sind die beiden mittleren Gleichspannungsanschlüsse DCMP, DCMN zwischen dem positiven Gleichspannungsanschluss DCP und dem negativen Gleichspannungsanschluss DCN angeordnet. Dabei sind die vier Gleichspannungsanschlüsse DCP, DCMP, DCMN, DCN von dem positiven Gleichspannungsanschluss DCP zu dem negativen Gleichspannungsanschluss DCN hin gemäß ihrem jeweiligen, vorgesehenen elektrischen Potenzial absteigend vom positiven Gleichspannungsanschluss DCP zum negativen Gleichspannungsanschluss DCM angeordnet. Beispielsweise sind die Gleichspannungsanschlüsse DCP, DCMP, DCMN, DCN jeweils im Wesentlichen äquidistant zueinander angeordnet.

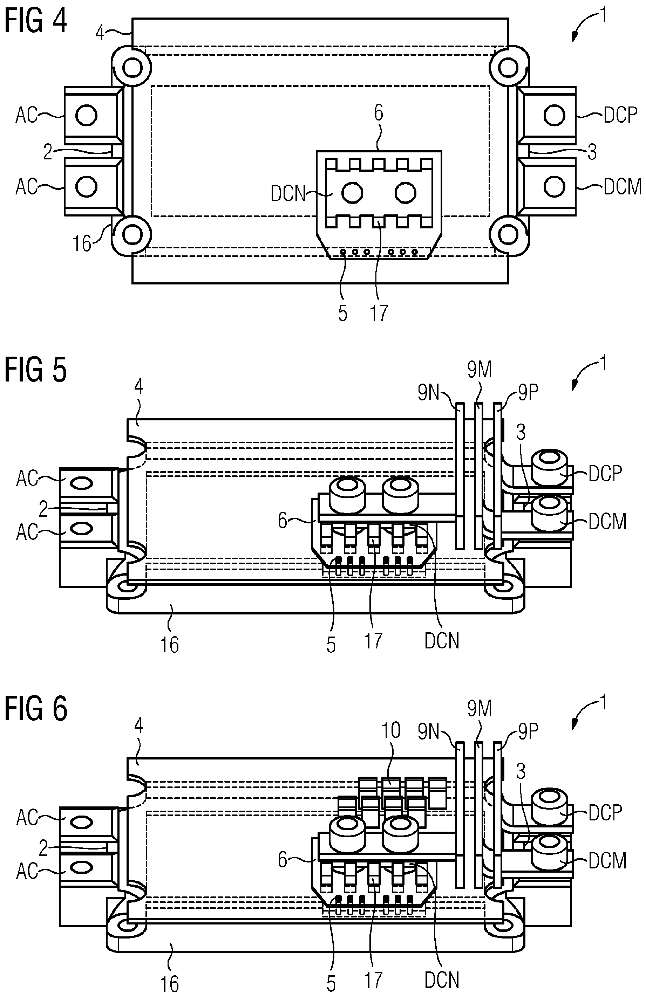

Die Figur 4 zeigt ein viertes Ausführungsbeispiel des vor-geschlagenen Leistungsmoduls 1, wobei wiederum eine Draufsicht dargestellt ist. Da das vierte Ausführungsbeispiel einige Ähnlichkeiten mit dem ersten Ausführungsbeispiel aufweist, werden im Folgenden einige Unterschiede erläutert.

Die Leiterplatte 4 weist zwischen der AC-Anschluss-Seite 2 und der DC-Anschluss-Seite 3 mehrere aus der Leiterplatte 4 herausragende Anschlusspins 5 aufweist, welche bspw. Anschlusspins eines nicht näher dargestellten Transistors bzw. Transistor-Moduls 20 sein können, welcher bzw. welches auf der Leiterplatte 4 bzw. auf der Rückseite der Leiterplatte 4 angeordnet sein kann. Dabei ist der negative Gleichspannungsanschluss DCN mit den Anschlusspins 5 über eine Verbindung 17 sowie eine Leiterfläche 6 elektrisch verbunden. Die Leiterfläche 6 kann bspw. als DCB ausgestaltet sein und insb. parallel zur Leiterplatte 4 angeordnet sein. Vorzugsweise überdeckt die Leiterplatte 4 die Leiterfläche 6 bei einer Draufsicht, d.h. wie bspw. in Figur 4 dargestellt, vollständig.

Die Figur 5 zeigt ein fünftes Ausführungsbeispiel des vor-geschlagenen Leistungsmoduls 1, wobei eine perspektivische und schematische Ansicht des Leistungsmoduls 1 dargestellt ist. Da das fünfte Ausführungsbeispiel einige Ähnlichkeiten mit dem vierten Ausführungsbeispiel aufweist, werden im Folgenden einige Unterschiede erläutert.

Das Leistungsmodul 1 weist weiterhin drei Stromschienen 9N, 9M und 9P auf, welche mit dem jeweiligen Gleichspannungsanschluss DCP, DCM und DCN elektrisch verbunden sind. Wie in Figur 5 angedeutet, sind die drei Stromschienen 9N, 9M, 9P im Wesentlichen parallel und äquidistant zueinander angeordnet. Dabei ist die Stromschiene 9M des mittleren elektrischen Potentials zwischen den Stromschienen 9P und 9N des positiven und negativen elektrischen Potentials angeordnet. Weiterhin haben die drei Stromschienen 9N, 9M und 9P jeweils einen rechteckigen Querschnitt, wobei die lange Seite des jeweiligen Rechtecks senkrecht zur Ebene der Leiterplatte 4 steht.

Die Figur 6 zeigt ein sechstes Ausführungsbeispiel des vorgeschlagenen Leistungsmoduls 1, wobei wiederum eine perspektivische und schematische Ansicht des Leistungsmoduls 1 dargestellt ist. Da das sechste Ausführungsbeispiel einige Ähnlichkeiten mit dem fünften Ausführungsbeispiel aufweist, werden im Folgenden einige Unterschiede erläutert.

Das Leistungsmodul 1 weist weiterhin mehrere Snubber-Kondensatoren 10 auf, welche auf der Leiterplatte 4 angeordnet sind und passend mit dem jeweiligen Gleichspannungsanschluss DCP, DCM, DCN elektrisch verbunden sind. Vorzugsweise ist die elektrische Verbindung zwischen dem jeweiligen Snubber-Kondensator 10 und dem jeweiligen Gleichspannungsanschluss DCP, DCM, DCN dabei höchstens zwei Mal so lang, insbesondere höchstens genauso lang oder höchstens halb so lang, ist wie der Abstand zwischen den beiden äußeren Gleichspannungsanschlüssen DCP, DCN.

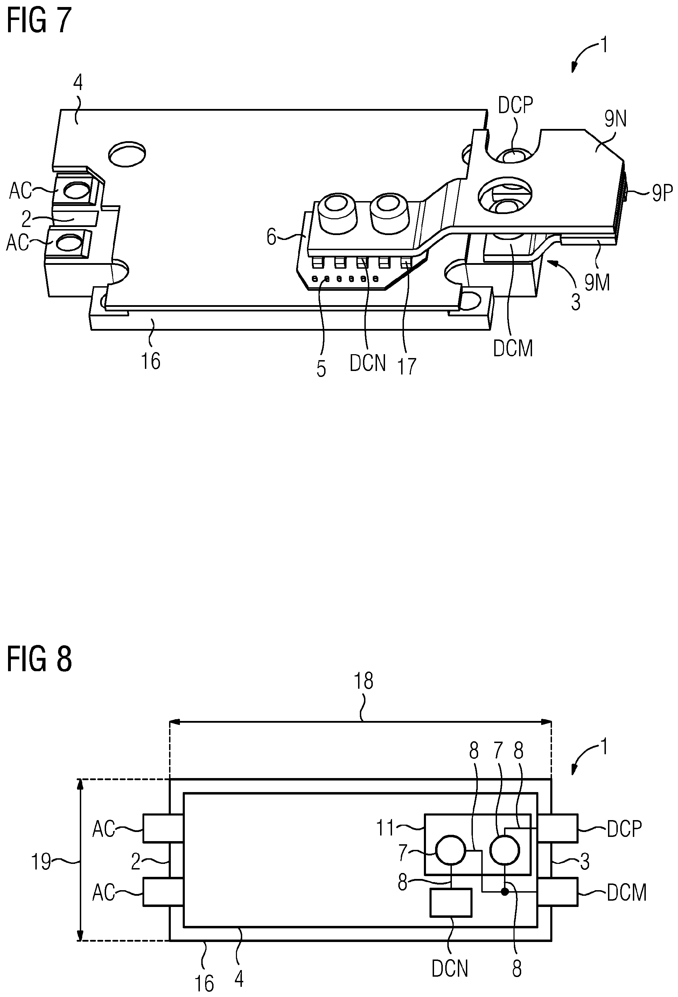

Die Figur 7 zeigt ein siebtes Ausführungsbeispiel des vor-geschlagenen Leistungsmoduls 1, wobei eine perspektivische und schematische Ansicht des Leistungsmoduls 1 dargestellt ist. Da das siebte Ausführungsbeispiel ebenfalls einige Ähnlichkeiten mit dem fünften Ausführungsbeispiel aufweist, werden im Folgenden einige Unterschiede erläutert.

Die drei Stromschienen 9N, 9M und 9P haben wiederum einen rechteckigen Querschnitt, wobei nun jedoch die kurze Seite des jeweiligen Rechtecks senkrecht zur Ebene der Leiterplatte 4 steht. Die flachen Stromschienen 9N, 9M und 9P sind somit parallel zur Ebene der Leiterplatte 4 angeordnet.

Die Figur 8 zeigt ein achtes Ausführungsbeispiel des vor-geschlagenen Leistungsmoduls 1, wobei wiederum eine schematische Ansicht dargestellt ist. Da das achte Ausführungsbeispiel ebenfalls einige Ähnlichkeiten mit dem ersten Ausführungsbeispiel aufweist, werden im Folgenden einige Unterschiede erläutert.

Das Leistungsmodul 1 weist zwei Kondensatoren 7 auf, von denen der eine Kondensator 7 mit dem positiven Gleichspannungsanschluss DCP und dem mittleren Gleichspannungsanschluss DCM über eine elektrische Verbindung 8 elektrisch verbunden ist und von denen der andere Kondensator 7 mit dem mittleren Gleichspannungsanschluss DCM und dem negativen Gleichspannungsanschluss DCN über eine weitere elektrische Verbindung 8 elektrisch verbunden ist. Dabei ist die jeweilige elektrische Verbindung 8 zwischen dem jeweiligen Kondensator 7 und dem jeweiligen Gleichspannungsanschluss DCP, DCM, DCN höchstens zwei Mal so lang, insbesondere höchstens genauso lang oder höchstens halb so lang, ist wie der Abstand zwischen den beiden äußeren Gleichspannungsanschlüssen DCP, DCN.

Weiterhin weist das Leistungsmodul 1 eine Kondensatorplatte 11 auf, auf welcher die Kondensatoren 7 angeordnet sind. Die Kondensatorplatte 11 ist dabei vorzugsweise parallel zur Leiterplatte 4 angeordnet ist, wobei der die Kondensatoren 7 auf der Kondensatorplatte 11 insbesondere innerhalb eines Rechteckes angeordnet ist, welches bei einer Draufsicht von den Gleichspannungsanschlüssen DCN, DCM, DCP begrenzt wird und welches parallel zur Leiterplatte 4 ausgerichtet ist.

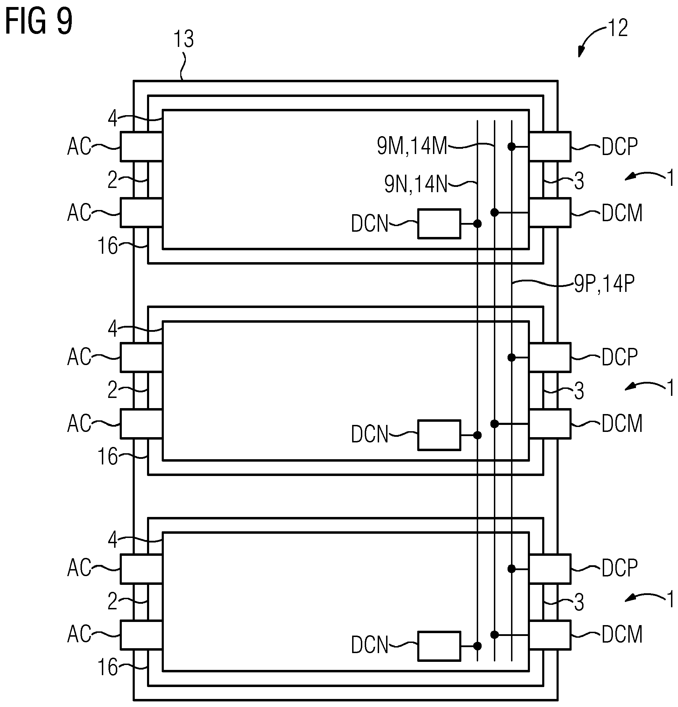

Die Figur 9 zeigt ein Ausführungsbeispiel des vorgeschlagenen elektrischen Geräts 12, wobei eine schematische Ansicht dargestellt ist.

Das elektrische Gerät 12 weist eine Grundplatte 13 auf, auf welcher drei Leistungsmodule 1 angeordnet sind, wobei die drei Leistungsmodule 1 insbesondere gemäß einem der obigen Ausführungsbeispiele ausgestaltet sein können. Die drei Leistungsmodule 1 sind dabei nebeneinander angeordnet und dabei so ausgerichtet, dass ihre jeweilige DC-Anschluss-Seite 3 in dieselbe Richtung weist, in der Figur 9 nach rechts. Weiterhin weist das elektrische Gerät 12 drei Geräte-Stromschienen 14P, 14M und 14N auf, welche mit dem jeweiligen Gleichspannungsanschluss DCP, DCM und DCN jeweiligen Leistungsmoduls 1 elektrisch verbunden sind. Bspw. kann das jeweilige Leistungsmodul 1 je drei Stromschienen 9P, 9M und 9N aufweisen, wie in den Ausführungsbeispielen 4 und 5 erläutert, wobei die Stromschienen 9P, 9M und 9N des jeweiligen Leistungsmoduls 1 einstückig mit den drei Geräte-Stromschienen 14P, 14M und 14N ausgestaltet sein können, wie in Figur 9 angedeutet.

Weiterhin wie in Figur 9 angedeutet, sind die drei Geräte-Stromschienen 14P, 14M und 14N im Wesentlichen parallel und äquidistant zueinander angeordnet. Dabei ist die Geräte-Stromschiene 14M des mittleren elektrischen Potentials zwischen den Geräte-Stromschienen 14P und 14N des positiven und negativen elektrischen Potentials angeordnet. Die drei Geräte-Stromschienen 14P, 14M und 14N können dabei jeweils einen rechteckigen Querschnitt aufweisen, wobei die lange oder die kurze Seite des jeweiligen Rechtecks senkrecht zur Ebene der Leiterplatten 4 steht.

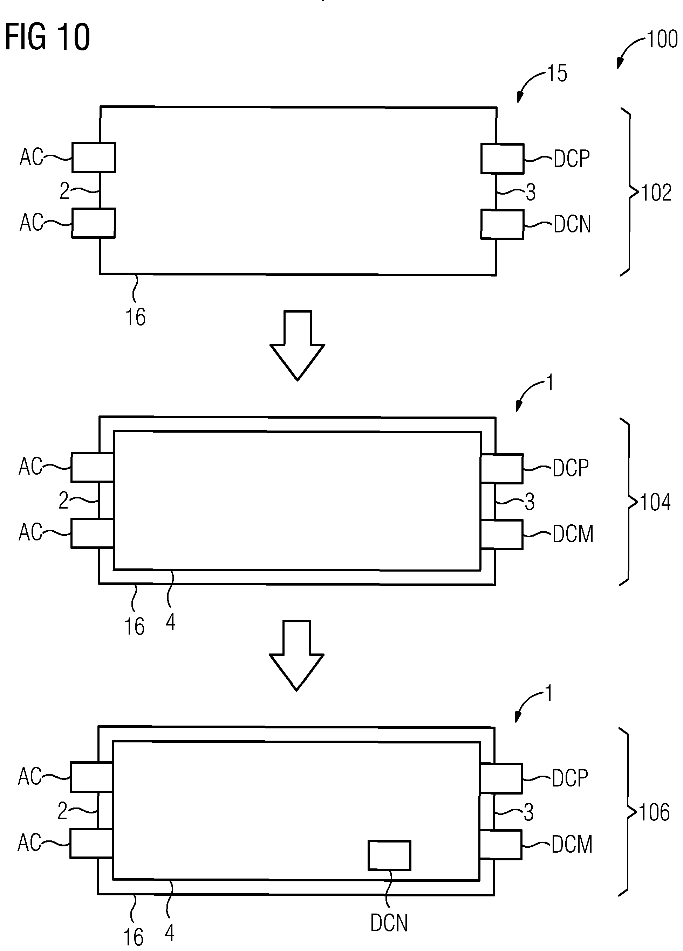

Die Figur 10 zeigt ein Ablaufschema eines Ausführungsbeispiels des vorgeschlagenen Verfahrens 100 zur Herstellung eines Ausführungsbeispiels eines Leistungsmoduls 1.

In einem ersten Schritt 102 wird ein Ausgangs-Leistungsmodul 15 aufweisend zwei an der AC-Anschluss-Seite 2 angeordnete Wechselspannungsanschlüsse AC und zwei, an der DC-Anschluss-Seite 3 angeordnete Gleichspannungsanschlüsse DCP, DCN bereitgestellt. Das Ausgangs-Leistungsmodul 15 weist weiterhin ein Gehäuse 16 auf, welches die Wechselspannungsanschlüsse AC und die Gleichspannungsanschlüsse DCP, DCN hält. Wie weiter oben bereits erwähnt kann ein solches Ausgangs-Leistungsmodul 15 beispielsweise ein herkömmliches Leistungsmodul sein, das bspw. aus der bereits erwähnten US8847328B1 bekannt ist.

In einem zweiten Schritt 104 wird eine passende Leiterplatte 4 bereitgestellt und zwischen der AC-Anschluss-Seite 2 und der DC-Anschluss-Seite 3 angeordnet. Dabei sind der mittlere Gleichspannungsanschluss DCM und der positive Gleichspannungsanschluss DCP an der DC-Anschluss-Seite 3 und bei einer Draufsicht außerhalb der Leiterplatte 4 angeordnet. Insbesondere wird dabei der negative Gleichspannungsanschluss DCN des Ausgangs-Leistungsmoduls 15 zu dem mittleren Gleichspannungsanschluss DCM des vorgeschlagenen Leistungsmoduls 1 umfunktioniert.

In einem dritten Schritt 106 wird der negative Gleichspannungsanschluss DCN zwischen der AC-Anschluss-Seite 2 und der DC-Anschluss-Seite 3 und bei einer Draufsicht im Bereich der Leiterplatte 4 bereitgestellt.

Vorzugsweise wird zusätzlich, bspw. in einem weiteren Schritt, eine jeweilige elektrische Verbindung der Wechselspannungsanschlüsse AC und des jeweiligen Gleichspannungsanschlusses DCP, DCM, DCN ist mit der Leiterplatte 4 hergestellt.

## Patentansprüche

1. Leistungsmodul (1) aufweisend eine AC-Anschluss-Seite (2) und eine, der AC-Anschluss-Seite (2) gegenüberliegende DC-Anschluss-Seite (3), wobei das Leistungsmodul (1) weiterhin umfasst:
- eine Leiterplatte (4),
- zumindest einen, an der AC-Anschluss-Seite (2) angeordneten Wechselspannungsanschluss (AC), und
- zumindest drei Gleichspannungsanschlüsse (DCP, DCM, DCN) umfassend einen oder mehr mittlere Gleichspannungsanschlüsse (DCM) sowie zwei äußere Gleichspannungsanschlüsse (DCP, DCN) umfassend einen positiven Gleichspannungsanschluss (DCP) und einen negativen Gleichspannungsanschluss (DCN),
wobei einer der mittleren Gleichspannungsanschlüsse (DCM) und einer der äußeren Gleichspannungsanschlüsse (DCP, DCN) jeweils an der DC-Anschluss-Seite (3) und bei einer Draufsicht außerhalb der Leiterplatte (4) angeordnet sind, und
**dadurch gekennzeichnet, dass**
der jeweilige, verbleibende der Gleichspannungsanschlüsse (DCP, DCM, DCN) zwischen der AC-Anschluss-Seite (2) und der DC-Anschluss-Seite (3) und bei einer Draufsicht im Bereich der Leiterplatte (4), insb. im Bereich eines Transistor-Moduls (20) des Leistungsmoduls (1), angeordnet ist.

2. Leistungsmodul (1) nach Anspruch 1,
wobei der jeweilige mittlere Gleichspannungsanschluss (DCM) zwischen dem positiven Gleichspannungsanschluss (DCP) und dem negativen Gleichspannungsanschluss (DCN) angeordnet ist.

3. Leistungsmodul (1) nach einem der vorhergehenden Ansprüche,
wobei die Leiterplatte (4) zwischen der AC-Anschluss-Seite (2) und der DC-Anschluss-Seite (3) zumindest einen aus der Leiterplatte (4) herausragenden Anschlusspin (5) aufweist, und
wobei der jeweilige, verbleibende der Gleichspannungsanschlüsse (DCP, DCM, DCN) mit dem jeweiligen Anschlusspin (5) elektrisch verbunden ist.

4. Leistungsmodul (1) nach Anspruch 3,
weiterhin aufweisend eine jeweilige Leiterfläche (6),
wobei die jeweilige Leiterfläche (6) zwischen dem jeweiligen Anschlusspin (5) und dem jeweiligen, verbleibenden der Gleichspannungsanschlüsse (DCP, DCM, DCN) angeordnet ist, und
wobei der jeweilige Anschlusspin (5) und der jeweilige, verbleibende der Gleichspannungsanschlüsse (DCP, DCM, DCN) mit der jeweiligen Leiterfläche (6) elektrisch verbunden ist.

5. Leistungsmodul nach Anspruch 4,
wobei die jeweilige Leiterfläche (6) parallel zur Leiterplatte (4) angeordnet ist, und/oder
wobei die Leiterplatte (4) bei einer Draufsicht die jeweilige Leiterfläche (6) vollständig überdeckt.

6. Leistungsmodul (1) nach einem der vorhergehenden Ansprüche,
weiterhin aufweisend zumindest zwei Kondensatoren (7),
wobei einer der Kondensatoren (7) mit dem einen der äußeren Gleichspannungsanschlüsse (DCP, DCN) und einem der mittleren Gleichspannungsanschlüsse (DCM) elektrisch verbunden ist und wobei ein anderer der Kondensatoren (7) mit dem anderen der äußeren Gleichspannungsanschlüsse (DCP, DCN) und einem der mittleren Gleichspannungsanschlüsse (DCM) elektrisch verbunden ist, und
wobei die elektrische Verbindung (8) zwischen dem jeweiligen Kondensator (7) und dem jeweiligen Gleichspannungsanschluss (DCP, DCM, DCN) höchstens zwei Mal so lang, insbesondere höchstens genauso lang oder höchstens halb so lang, ist wie der Abstand zwischen den beiden äußeren Gleichspannungsanschlüssen (DCP, DCN).

7. Leistungsmodul (1) nach einem der vorhergehenden Ansprüche,
weiterhin aufweisend eine jeweilige Stromschiene (9), welche mit dem jeweiligen Gleichspannungsanschluss (DCP, DCM, DCN) und optional mit dem jeweiligen Kondensator (7) elektrisch verbunden ist,
wobei die Stromschienen (9) zumindest überwiegend parallel zueinander angeordnet sind, und
wobei die jeweilige Stromschiene (9) des jeweiligen mittleren Gleichspannungsanschlusses (DCM) zwischen den Stromschienen (9) der beiden äußeren Gleichspannungsanschlüsse (DCP, DCN) angeordnet ist.

8. Leistungsmodul (1) nach einem der vorhergehenden Ansprüche,
weiterhin aufweisend zumindest einen Snubber-Kondensator (10),
wobei der jeweilige Snubber-Kondensator (10) auf der Leiterplatte (4) angeordnet ist,
wobei der jeweilige Snubber-Kondensator (10) mit dem jeweiligen Gleichspannungsanschluss (DCP, DCM, DCN) elektrisch verbunden ist, und
wobei die elektrische Verbindung zwischen dem jeweiligen Snubber-Kondensator (10) und dem jeweiligen Gleichspannungsanschluss (DCP, DCM, DCN) höchstens zwei Mal so lang, insbesondere höchstens genauso lang oder höchstens halb so lang, ist wie der Abstand zwischen den beiden äußeren Gleichspannungsanschlüssen (DCP, DCN).

9. Leistungsmodul (1) nach einem der vorhergehenden Ansprüche,
wobei das Leistungsmodul (1) mit einer elektrischen Leistung von zumindest mehreren 10 kW, vorzugsweise 40 kW bis 500 kW, mit einer Wechselspannung von zumindest mehreren 100 V, vorzugsweise 280 V bis 800 V, mit einer Gleichspannung von zumindest mehreren 100 V, vorzugsweise 800 V bis 1500 V, und/oder elektrischen Strömen von mehreren 10 A, vorzugsweise 70 A bis 1000 A, betreibbar ist.

10. Leistungsmodul (1) nach einem der vorhergehenden Ansprüche,
wobei das Leistungsmodul (1) eine Grundfläche von 80 cm² bis 100 cm² aufweist,
wobei die Grundfläche insbesondere rechteckig ist mit einer Seitenlänge von ca. 150 mm an seiner langen Seite (18) und mit einer Seitenlänge von ca. 62,5 mm an seiner kurzen Seite (19).

11. Elektrisches Gerät (12), insbesondere Umrichter, umfassend zumindest ein Leistungsmodul (1), vorzugsweise zumindest drei Leistungsmodule (1), nach einem der vorhergehenden Ansprüche.

12. Elektrisches Gerät (12) nach Anspruch 11,
aufweisend eine Grundplatte (13) und zumindest zwei Leistungsmodule (1) nach einem der Ansprüche 1 bis 10,
wobei die Leistungsmodule (1) derart nebeneinander auf der Grundplatte (13) angeordnet sind, dass die DC-Anschluss-Seiten (3) der Leistungsmodule (1) in dieselbe Richtung weisen,
weiterhin aufweisend eine jeweilige Geräte-Stromschiene (14), welche mit dem jeweiligen Gleichspannungsanschluss (DCP, DCM, DCN) des jeweiligen Leistungsmoduls (1) und optional mit dem jeweiligen Kondensator (7) elektrisch verbunden ist, und
wobei die Geräte-Stromschienen (14) zumindest abschnittsweise parallel zueinander angeordnet sind.

13. Verfahren zur Herstellung eines Leistungsmoduls (1) nach einem der Ansprüche 1 bis 10 umfassend die Verfahrensschritte:
- Bereitstellen eines Ausgangs-Leistungsmoduls (15) aufweisend:
∘ zumindest einen, an der AC-Anschluss-Seite (2) angeordneten Wechselspannungsanschluss (AC),
∘ zwei, an der DC-Anschluss-Seite (3) angeordnete Gleichspannungsanschlüsse (DCP, DCM, DCN),
- Bereitstellen der Leiterplatte (4) zwischen der AC-Anschluss-Seite (2) und der DC-Anschluss-Seite (3) derart, dass einer der mittleren Gleichspannungsanschlüsse (DCM) und einer der äußeren Gleichspannungsanschlüsse (DCP, DCN) jeweils an der DC-Anschluss-Seite (3) und bei einer Draufsicht außerhalb der Leiterplatte (4) angeordnet sind, und
- Bereitstellen des zumindest einen weiteren Gleichspannungsanschlusses (DCP, DCM, DCN) zwischen der AC-Anschluss-Seite (2) und der DC-Anschluss-Seite (3) und bei einer Draufsicht im Bereich der Leiterplatte (4), insb. im Bereich eines Transistor-Moduls (20) des Leistungsmoduls (1).

## Claims

1. Power module (1) having an AC terminal side (2) and a DC terminal side (3) lying opposite the AC terminal side (2), wherein the power module (1) furthermore comprises:
- a printed circuit board (4),
- at least one alternating current terminal (AC) disposed on the AC terminal side (2), and
- at least three direct current terminals (DCP, DCM, DCN) comprising one or more middle direct current terminals (DCM) as well as two outer direct current terminals (DCP, DCN) comprising a positive direct current terminal (DCP) and a negative direct current terminal (DCN),
wherein one of the middle direct current terminals (DCM) and one of the outer direct current terminals (DCP, DCN) are disposed on the DC terminal side (3) in each case and, in a plan view, are disposed outside of the printed circuit board (4), and
**characterised in that**
the respective remainder of the direct current terminals (DCP, DCM, DCN) are disposed between the AC terminal side (2) and the DC terminal side (3) and, in a plan view, in the region of the printed circuit board (4), in particular in the region of a transistor module (20) of the power module (1).

2. Power module (1) according to claim 1,
wherein the respective middle direct current terminal (DCM) is disposed between the positive direct current terminal (DCP) and the negative direct current terminal (DCN).

3. Power module (1) according to one of the preceding claims,
wherein the printed circuit board (4) has at least one terminal pin (5) protruding from the printed circuit board (4) between the AC terminal side (2) and the DC terminal side (3), and
wherein the respective remaining terminal of the direct current terminals (DCP, DCM, DCN) is electrically connected to the respective terminal pin (5).

4. Power module (1) according to claim 3,
furthermore having a respective conductor surface (6),
wherein the respective conductor surface (6) is disposed between the respective terminal pin (5) and the respective remaining terminal of the direct current terminals (DCP, DCM, DCN), and wherein the respective terminal pin (5) and the respective remaining terminal of the direct current terminals (DCP, DCM, DCN) is electrically connected to the respective conductor surface (6).

5. Power module according to claim 4,
wherein the respective conductor surface (6) is disposed parallel to the printed circuit board (4), and/or
wherein the printed circuit board (4), in a plan view, completely covers the respective conductor surface (6).

6. Power module (1) according to one of the preceding claims, furthermore having at least two capacitors (7),
wherein one of the capacitors (7) is electrically connected to one of the outer direct current terminals (DCP, DCN) and to one of the middle direct current terminals (DCM) and wherein another of the capacitors (7) is electrically connected to the other of the outer direct current terminals (DCP, DCN) and to one of the middle direct current terminals (DCM), and
wherein the electrical connection (8) between the respective capacitor (7) and the respective direct current terminal (DCP, DCM, DCN) is at most twice as long, especially at most exactly the same length or at most half as long as the distance between the two outer direct current terminals (DCP, DCN).

7. Power module (1) according to one of the preceding claims, furthermore having a respective busbar (9), which is electrically connected to the respective direct current terminal (DCP, DCM, DCN) and optionally to the respective capacitor (7),
wherein the busbars (9) are at least predominantly disposed in parallel to one another, and
wherein the respective busbar (9) of the respective middle direct current terminal (DCM) is disposed between the busbars (9) of the two outer direct current terminals (DCP, DCN).

8. Power module (1) according to one of the preceding claims, furthermore having at least one snubber capacitor (10),
wherein the respective snubber capacitor (10) is disposed on the printed circuit board (4),
wherein the respective snubber capacitor (10) is electrically connected to the respective direct current terminal (DCP, DCM, DCN), and
wherein the electrical connection between the respective snubber capacitor (10) and the respective direct current terminal (DCP, DCM, DCN) is at most twice as long, especially at most exactly the same length or at most half as long as the distance between the two outer direct current terminals (DCP, DCN).

9. Power module (1) according to one of the preceding claims, wherein the power module (1) is able to be operated with an electrical power of at least several 10s of kilowatts, preferably 40 kW to 500 kW, with an alternating current of at least several 100s of volts, preferably 280 V to 800 V, with a direct current of at least several 100s of volts, preferably 800 V to 1500 V, and/or electrical currents of several 10s of amperes, preferably 70 A to 1000 A.

10. Power module (1) according to one of the preceding claims,
wherein the power module (1) has a surface area of 80 cm² to 100 cm²,
wherein the surface area is especially rectangular with a length of around 150 mm on its long side (18) and with a length of around 62.5 mm on its short side (19).

11. Electrical device (12), especially a converter, comprising at least one power module (1), preferably at least three power modules (1), according to one of the preceding claims.

12. Electrical device (12) according to claim 11,
having a base board (13) and at least two power modules (1) according to one of claims 1 to 10,
wherein the power modules (1) are disposed alongside one another on the base board (13) in such a way that the DC terminal sides (3) of the power modules (1) point in the same direction,
furthermore having a respective device busbar (14), which is electrically connected to the respective direct current terminal (DCP, DCM, DCN) of the respective power module (1) and optionally to the respective capacitor (7), and
wherein the device busbars (14) are disposed, at least in sections, parallel to one another.

13. Method for producing a power module (1) according to one of claims 1 to 10 comprising the method steps:
- provision of an initial power module (15) having:
∘ at least one alternating current terminal (AC), disposed on the AC terminal side (2),
∘ two direct current terminals (DCP, DCM, DCN) disposed on the DC terminal side (3),
- provision of the printed circuit board (4) between the AC terminal side (2) and the DC terminal side (3) in such a way that one of the middle direct current terminals (DCM) and one of the outer direct current terminals (DCP, DCN) are disposed in each case on the DC terminal side (3) and, in a plan view, are disposed outside the printed circuit board (4), and
- provision of the at least one further direct current terminal (DCP, DCM, DCN) between the AC terminal side (2) and the DC terminal side (3) and, in a plan view, in the region of the printed circuit board (4), in particular in the region of a transistor module (20) of the power module (1).

## Revendications

1. Module (1) de puissance, comportant un côté (2) de borne de courant alternatif et un côté (3) de borne de courant continu, opposé au côté (2) de borne de courant alternatif, dans lequel le module (1) de puissance comprend en outre :
- une plaquette (4) à circuit imprimé,
- au moine une borne (AC) de tension alternative, disposée du côté (2) de borne de courant alternatif, et
- au moins trois bornes (DCP, DCM, DCN) de tension continue, comprenant une ou plusieurs bornes (DCM) médianes de tension continue, ainsi que deux bornes (DCP, DCN) extérieures de tension continue comprenant une borne (DCP) positive de tension continue et une borne (DCN) négative de tension continue,
dans lequel l'une des bornes (DCM) médianes de tension continue et l'une des bornes (DCP, DCN) extérieures de tension continue sont disposées respectivement du côté (3) de borne (DCM) de tension continue et, dans une vue en plan, à l'extérieur de la plaquette (4) à circuit imprimé, et
**caractérisé en ce que**
les bornes (DCP, DCM, DCN) respectives restantes de tension continue sont disposées entre le côté (2) de borne de courant alternatif et le côté (3) de borne de courant continu et, dans une vue en plan, dans la partie de la plaquette (4) à circuit imprimé, en particulier dans la partie d'un module (20) de transistor du module (1) de puissance.

2. Module (1) de puissance suivant la revendication 1,
dans lequel la borne (DCM) médiane respective de tension continue est disposée entre la borne (DCP) positive de tension continue et la borne (DCN) négative de tension continue.

3. Module (1) de puissance suivant l'une des revendications précédentes,
dans lequel la plaquette (4) à circuit imprimé a, entre le côté (2) de borne de courant alternatif et le côté (3) de borne de courant continu, au moins une broche (5) de connexion sortant de la plaquette (4) à circuit imprimé, et
dans lequel celle respective restante des bornes (DCP, DCM, DCN) de tension continue est connectée électriquement à la broche (5) respective de connexion.

4. Module (1) de puissance suivant la revendication 3, comportant en outre une surface (6) conductrice respective,
dans lequel la surface (6) conductrice respective est disposée entre la broche (5) respective de connexion et celles respectives restantes des bornes (DCP, DCM, DCN) de tension continue, et
dans lequel la broche (5) respective de connexion et celles respectives restantes des bornes (DCP, DCM, DCN) de tension continue sont connectées électriquement à la surface (6) conductrice respective.

5. Module de puissance suivant la revendication 4,
dans lequel la surface (6) conductive respective est disposée parallèlement à la plaquette (4) à circuit imprimé, et/ou
dans lequel la plaquette (4) conductrice recouvre complètement dans une vue en plan la surface (6) conductrice respective.

6. Module (1) de puissance suivant l'une des revendications précédentes,
comportant en outre au moins deux condensateurs (7),
dans lequel l'un des condensateurs (7) est connecté électriquement à la une des bornes (DCP, DCN) extérieures de tension continue et à l'une des bornes (DCM) médianes de tension continue et
dans lequel un autre des condensateurs (7) est connecté électriquement à l'autre des bornes (DCP, DCN) extérieures de tension continue et à l'une des bornes (DCM) médianes de tension continue, et
dans lequel la connexion (8) électrique entre le condensateur (7) respectif et la borne (DCP, DCM, DCN) respective de tension continue est au plus deux fois aussi longue, en particulier au plus exactement aussi longue, ou au plus à moitié aussi longue que la distance entre les deux bornes (DCP, DCN) extérieures de tension continue.

7. Module (1) de puissance suivant l'une des revendications précédentes,
comportant en outre un rail (9) respectif de courant, qui est connecté électriquement à la borne (DCP, DCM, DCN) respective de tension continue et éventuellement au condensateur (7) respectif, dans lequel les rails (9) de courant sont disposés en étant au moins principalement parallèles entre eux, et
dans lequel le rail (9) de courant respectif de la borne (DCM) médiane respective de tension continue est disposé entre les rails (9) de courant des deux bornes (DCP, DCN) extérieures de tension continue.

8. Module (1) de puissance suivant l'une des revendications précédentes,
comportant en outre au moins un condensateur (10) snubber,
dans lequel le condensateur (10) snubber est monté sur la plaquette (4) à circuit imprimé,
dans lequel le condensateur (10) snubber respectif est connecté électriquement à la borne (DCP, DCM, DCN) respective de tension continue, et
dans lequel la connexion électrique entre le condensateur (10) snubber respectif et la borne (DCP, DCM, DCN) respective de tension continue est au plus deux fois aussi longue, en particulier au plus exactement aussi longue, ou au plus à moitié aussi longue que la distance entre les deux bornes (DCP, DCN) extérieures de tension continue.

9. Module (1) de puissance suivant l'une des revendications précédentes,
dans lequel le module (1) de puissance peut fonctionner à une puissance électrique d'au moins 10 kW, de préférence de 40 kW à 500 kW, avec une tension alternative d'au moins plusieurs 100 V, de préférence de 280 V à 800 V, avec une tension continue d'au moins plusieurs 100 V, de préférence de 800 V à 1500 V et/ou des courants électriques de plusieurs 10 A, de préférence de 70 A à 1000 A.

10. Module (1) de puissance suivant l'une des revendications précédentes,
dans lequel le module (1) de puissance a une surface de base de 80 cm² à 100 cm²,
dans lequel la surface de base est en particulier rectangulaire en ayant une longueur de côté d'environ 150 mm sur son grand côté (18) et une longueur de côté d'environ 62,5 mm sur son petit côté (19) .

11. Appareil (12) électrique, en particulier convertisseur, comprenant au moins un module (1) de puissance, de préférence au moins trois modules (1) de puissance suivant l'une des revendications précédentes.

12. Appareil (12) électrique suivant la revendication 11, comportant une plaque (13) de base et au moins deux modules (1) de puissance suivant l'une des revendications 1 à 10,
dans lequel les modules (1) de puissance sont disposés les uns à côté des autres sur la plaque (13) de base, de manière à ce que les côtés (3) de borne de courant continu des modules (1) de puissance soient tournés dans le même sens,
comportant en outre un rail (14) de courant d'appareil respectif, qui est connecté électriquement à la borne (DCP, DCM, DCN) respective de tension continue du module (1) de puissance respectif et éventuellement au condensateur (7) respectif, et
dans lequel les rails (14) de courant d'appareil sont disposés en étant au moins un par tronçon parallèles entre eux.

13. Procédé de fabrication d'un module (1) de puissance suivant l'une des revendications 1 à 10, comprenant les stades de procédé :
- on se procure un module (15) de puissance de départ ayant :
∘ au moins une borne (AC) de courant alternatif disposée d'un côté (2) de borne de courant alternatif,
∘ deux bornes (DCP, DCM, DCN) de tension continue disposées du côté (3) de borne de courant continu,
- on met la plaquette (4) à circuit imprimé entre le côté (2) de borne de courant alternatif et le côté (3) de borne de courant continu, de manière à ce que l'une des bornes (DCM) médianes de tension continue et l'une des bornes (DCP, DCN) extérieures de tension continue soient disposées respectivement du côté (3) de borne de tension continue et en vue en plan à l'extérieur de la plaquette (4) à circuit imprimé, et
- on met la au moins une autre borne (DCP, DCM, DCN) de tension continue entre le côté (2) de borne de tension alternative et le côté (3) de borne de tension continue et dans une vue en plan dans la partie de la plaquette (4) à circuit imprimé, en particulier dans la partie d'un module (20) de transistor d'un module (1) de puissance.
